# EUROPEAN PATENT APPLICATION

(11) **EP 2 061 095 A1**
(43) Date of publication of application: **20.05.2009**
(21) Application number: 07806388.0
(22) Date of filing: 30.08.2007
(51) Int. Cl.: H01L 33/00

(54) **LIGHT-EMITTING DEVICE**

(30) Priority: 30.08.2006 JP 2006233308; 28.09.2006 JP 2006263858
(71) Applicant: Kyocera Corporation, Kyoto-shi Kyoto 612-8501 (JP)
(72) Inventor: SAKUMOTO, Daisuke, Higashiomi-shi Shiga 529-1595 (JP); MATSUURA, Shingo, Higashiomi-shi Shiga 529-1595 (JP); YANAGISAWA, Mitsuo, Higashiomi-shi Shiga 529-1595 (JP)
(74) Representative: Beetz & Partner
(86) International application number: PCT/JP2007/066911
(87) International publication number: WO 2008/026699

(57) **Abstract**

A light-emitting device includes a base, a light-emitting chip mounted on the base and a light emitter disposed above the light-emitting chip. The light-emitting device further includes an optical member contacting with side surfaces of the light-emitting chip and including a transparent material. The optical member has an opening in which the light-emitting chip is disposed and a flat upper surface opposed to the light emitter.

## Description

### Technical Field

The present invention relates to a light-emitting device having a light-emitting chip such as a light-emitting diode.

### Background Art

In recent years, developments directed toward producing a light-emitting device having a light-emitting chip such as a light-emitting diode have been under way. The light-emitting device is used for a lighting fixture, for example. The light-emitting device has a light emitter for converting a wavelength of a light emitted from the light-emitting chip. The light emitter includes a fluorescent material which is excited by the light emitted from the light-emitting chip.

### Disclosure of the invention

### Technical Problem

In conventional light-emitting devices, there has been a demand for enhancement in the efficiency of wavelength conversion for light emanating from a light-emitting chip. In order to increase the efficiency of wavelength conversion, it is necessary to reduce the proportion of that part of light emitted from a light-emitting chip which disappears on its way to a light emitter.

### Technical Solution

According to one embodiment of the invention, a light-emitting device includes a base, a light-emitting chip mounted on the base, and a light emitter disposed above the light-emitting chip. The light-emitting chip includes a semiconductor material and generates a first light. The light emitter has a sheet-like shape and includes a fluorescent material excited by the first light to emit a second light. The light-emitting device further includes an optical member contacting side surfaces of the light-emitting chip and including a transparent material. The optical member has an opening in which is disposed the light-emitting chip and a flat upper surface opposed to the light emitter.

According to another embodiment of the invention, a light-emitting device includes a base, a light-emitting chip mounted on the base, and a light emitter disposed above the light-emitting chip. The light-emitting chip includes a semiconductor material and generates a first light. The light emitter has a sheet-like shape and includes a fluorescent material excited by the first light to emit a second light. The light-emitting device further includes an optical member disposed between the light-emitting chip and the light emitter and including a transparent material. The optical member has a flat upper surface opposed to the light emitter.

### Advantageous effects

The light-emitting device in accordance with one embodiment of the invention includes the optical member which has the flat upper surface opposed to the light emitter and contacts with the side surfaces of the light-emitting chip. In this construction, the deviation of light emission distribution can be reduced.

The light-emitting device in accordance with another embodiment of the invention includes the optical member which has the flat upper surface opposed to the light emitter and is disposed between the light-emitting chip and the light emitter. In this construction, the deviation of light emission distribution can be reduced.

### Brief Description of Drawings

Fig. 1 is a perspective view illustrating an embodiment of the illuminating apparatus of the invention.
Fig. 2 is a view illustrating the circuit configuration of the illuminating apparatus.
Fig. 3 is a perspective view illustrating an embodiment of the light-emitting device of the invention.
Fig. 4 is.a sectional view of the light-emitting device illustrated in Fig. 3.
Fig. 5 is an enlarged view of the light-emitting chip and the optical member illustrated in Fig. 4.
Fig. 6 is an enlarged view of the light-emitting chip and the optical member illustrated in Fig. 3.
Fig. 7 is a perspective view of the light-emitting chip.
Fig. 8 is a perspective view of another light-emitting chip.
Fig. 9 is a view illustrating how light travels in the light-emitting device illustrated in Fig. 4.
Fig. 10 is a view illustrating the method for manufacturing the light-emitting device.
Fig. 11 is a view illustrating the method for manufacturing the light-emitting device.
Fig. 12 is a view illustrating the method for manufacturing the light-emitting device.
Fig. 13 is a view illustrating the method for manufacturing the light-emitting device.
Fig. 14 is a perspective view illustrating another embodiment of the light-emitting device of the invention.
Fig. 15 is a sectional view of the light-emitting device illustrated in Fig. 14.
Fig. 16 is a view illustrating how light travels in the light-emitting device of another embodiment.
Fig. 17 is a perspective view illustrating still another embodiment of the light-emitting device of the invention.
Fig. 18 is a sectional view of the light-emitting device illustrated in Fig. 17.
Fig. 19 is a view illustrating how light travels in the light-emitting device illustrated in Fig. 18.
Fig. 20 is a sectional view illustrating yet a further embodiment of the light-emitting device of the invention.
Fig. 21 is a view illustrating how light travels in the light-emitting device illustrated in Fig. 20.

### Best Mode for Carrying out the Invention

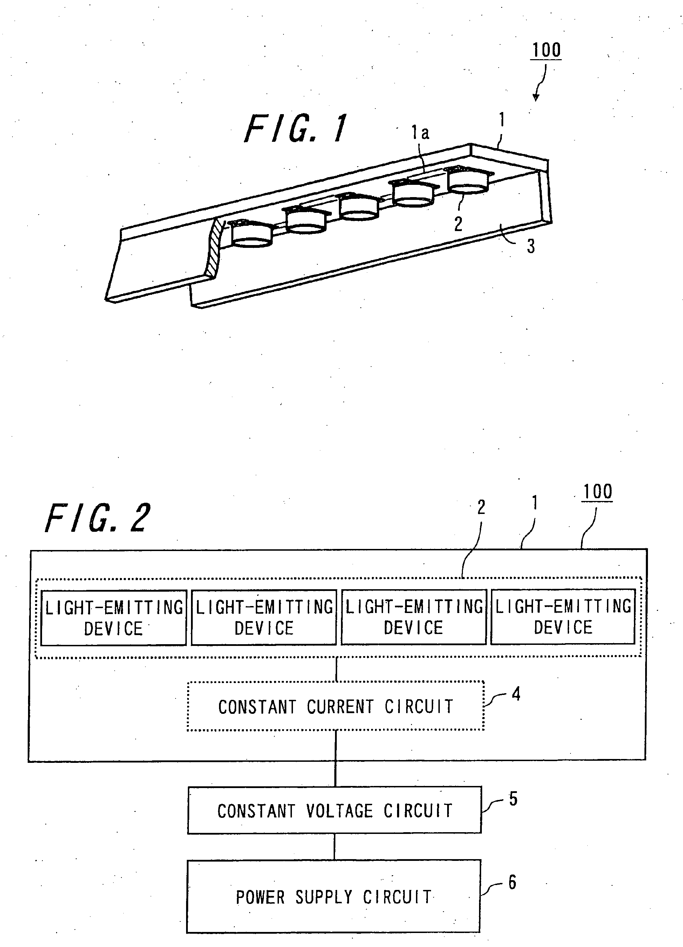

Hereinafter, the embodiments of the invention will be described in detail with reference to drawings. As illustrated in Fig. 1, an illuminating apparatus 100 includes a substrate 1, a plurality of light-emitting devices 2 mounted on the substrate 1, and a light-reflecting member 3. The substrate 1 has a conductor pattern 1a. A plurality of the light-emitting devices 2 are electrically connected to the conductor pattern 1a. The light-reflecting member 3 is placed at a location where it can be reached by at least part of light emitted from a plurality of the light-emitting devices 2. In Fig. 1, the light-reflecting member 3 is disposed beside a plurality of the light-emitting devices 2. Referring to Fig. 2, the circuit configuration of the illuminating apparatus 100 will be described. The illuminating apparatus 100 comprises a plurality of the light-emitting devices 2 disposed on the substrate 1 and a constant current circuit 4. A constant voltage circuit 5 is electrically connected to the constant current circuit 4 of the illuminating apparatus 100. A power supply circuit 6 is electrically connected to the constant current circuit 5.

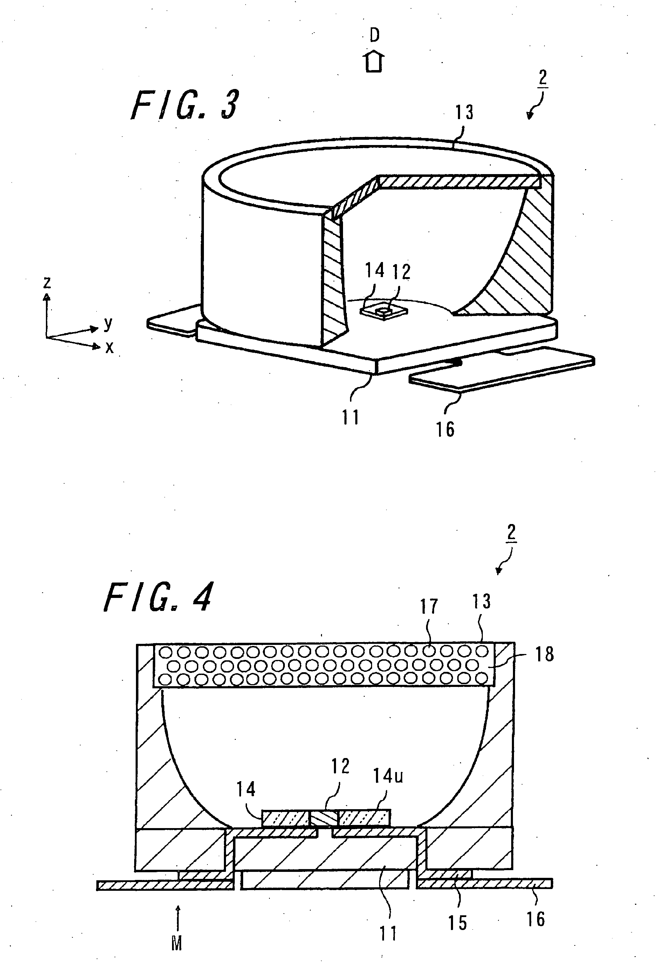

As illustrated in Fig. 3, the light-emitting device 2 includes a base 11, a light-emitting chip 12 mounted on the base 11, and a light emitter (wavelength converter) 13 disposed above the light-emitting chip 12. The light-emitting device 2 further includes an optical member 14 contacting with the light-emitting chip 12. The base 11 is made of an insulating material. As illustrated in Fig. 4, the base 11 has a conductive pattern 15. A lead terminal 16 is electrically connected to the conductive pattern 15 and disposed at a mounting surface M of the light-emitting device 2.

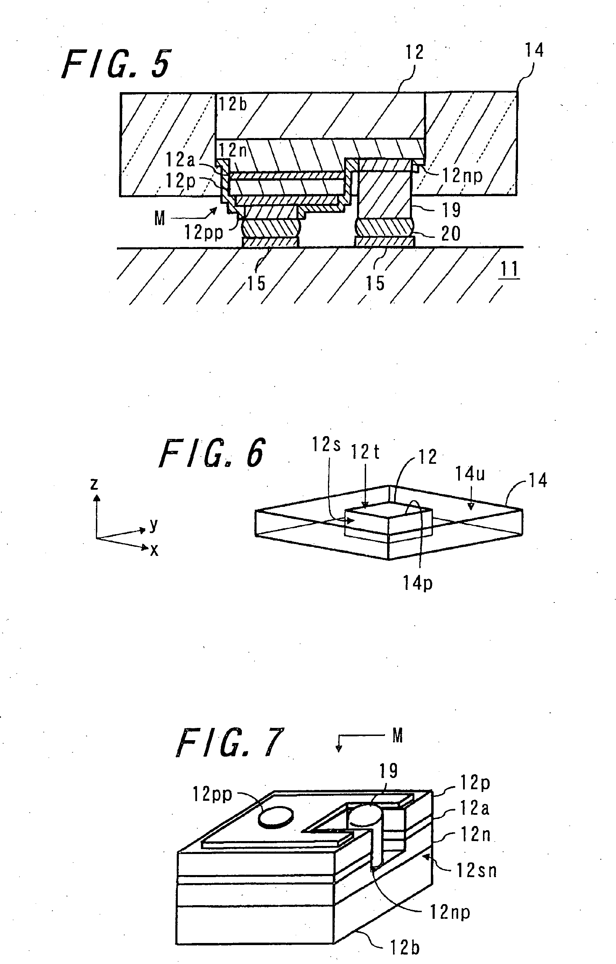

The light-emitting chip 12 is a light-emitting diode which generates a first light. The first light has at least part of wavelength range from 370 nm to 400 nm (ultraviolet) or at least part of wavelength range from 450 nm to 500 nm (blue). As illustrated in Fig. 5, the light-emitting chip 12 includes a first semiconductor layer (n-type semiconductor layer) 12n stacked on a substrate 12b, a semiconductor active layer 12a, and a second semiconductor layer (p-type semiconductor layer) 12p. The n-type semiconductor layer 12n, the semiconductor active layer 12a, and the p-type semiconductor layer 12p are made of gallium nitride (GaN). As another example of the light-emitting chip 12, there is the one made of aluminum nitride (AlN). The light-emitting chip 12 includes a first electrode pad (n-side electrode pad) 12np disposed on the n-type semiconductor layer 12n and a second electrode pad (p-side electrode pad) 12pp disposed on the p-type semiconductor layer 12p. The light-emitting chip 12 further includes a metal contact member 19 disposed on the n-side electrode pad 12np. The n-side electrode pad 12np and the p-side electrode pad 12pp are each electrically connected, via solder 20, to the conductive pattern 15 disposed on the base 11. The light-emitting chip 12 is mounted on the base 11 by flip-chip bonding. That is, the light-emitting chip 12 is mounted on the base 11, with the mounting surface M having the n-side electrode pad 12np and the p-side electrode pad 12pp opposed to the base 11.

The wavelength converter 13 is apart from the light-emitting chip 12 and has a sheet-like shape. The wavelength converter 13 includes a fluorescent.material 17 which is excited by the first light to emit a second light. In this embodiment, the second light'has a second wavelength which differs from a first wavelength of the first light. In the light-emitting device 2 having the light-emitting chip 12 which generates ultraviolet light, the fluorescent material 17 emits light having at least part of wavelength range from 625 nm to 740 nm (red), light having at least part of wavelength range from 520 nm to 565 nm (green), and light having at least part of wavelength range from 450 nm to 500 nm (blue). The light-emitting device 2 emits a mixed light (white light) of red light, green light, and blue light emitted from the wavelength converter 13. In the light-emitting device 2 having the light-emitting chip 12 which generates blue light, the fluorescent material 17 emits light having at least part of wavelength range from 565 nm to 590 nm (yellow). The light-emitting device 2 emits a mixed light (white light) of blue light emitted from the light-emitting chip and yellow light emitted from the wavelength converter 13.

In another example of the light-emitting device 2 having the light-emitting chip 12 which generates blue light, the fluorescent material 17 emits light having at least part of wavelength range from 625 nm to 740.nm (red) and light having at'least part of wavelength range from 520 nm to 565 nm (green). The light-emitting device 2 emits a mixed light (white light) of blue light emitted from the light-emitting chip 12, and red light and green light emitted from the wavelength converter 13. The wavelength converter 13 further includes a resin material 18 containing the fluorescent material 17. The resin material 18 is silicone resin which exhibits transparency.

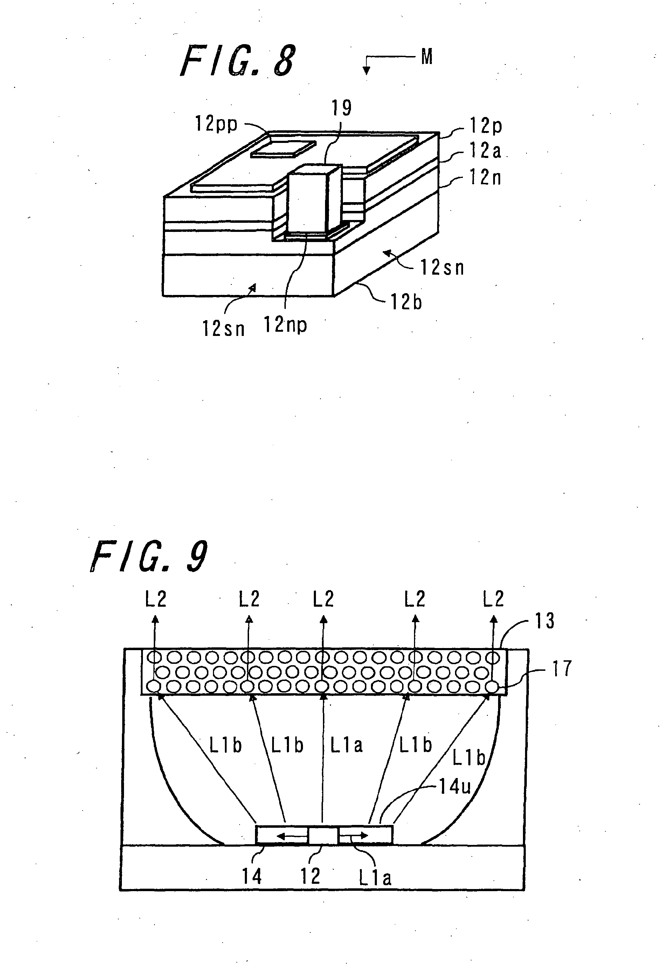

As illustrated in Fig. 5, the optical member 14 covers the active layer 12a of the light-emitting chip 12. As illustrated'in Fig. 6, the optical member 14 contacts with side surfaces 12s of the light-emitting chip 12. The light-emitting chip 12 is mounted on an xy plane in a virtual xyz space. The optical member 14 has a flat upper surface 14u opposed to the wavelength converter 13. The optical member 14 has an opening 14p in which is disposed the light-emitting chip 12. The optical member 14 includes a transparent material. The transparent material is resin or glass. The optical member 14 contacts at least with the side surface 12s located nearest the p-side electrode pad 12p. Referring to Figs. 7 and 8, the structure of the light-emitting chip 12 will be described in further detail. In Fig. 7, the n-type semiconductor layer 12n is exposed from the p-type semiconductor layer 12p as seen at the side of the mounting surface M. The optical member 14 is formed at least on a side surface 12sn located nearest the n-side electrode pad 12np. In Fig. 8, the n-type semiconductor layer 12n is exposed from the p-type semiconductor layer 12p as seen at the corner of the mounting surface M. The optical member 14 is formed at least.on the side surface 12sn located nearest the n-side electrode pad 12np. As illustrated in Fig. 6, the optical member 14 surrounds the side surfaces 12s of the light-emitting chip 12.

Referring to Fig. 9, how light travels in the light-emitting device 2 will be described. The first light L1a emitted from the light-emitting chip 12 travels upward and sideward from the light-emitting chip 12. The first light L1a, now traveling sideways in relation to the light-emitting chip 12, travels further from the.flat upper surface 14u of the optical member 14 toward the wavelength converter 13. The light radiated from the upper surface 14u is indicated by a symbol L1b. The first light L1a and L1b is subjected to wavelength conversion by the fluorescent material 17 of the wavelength converter 13. The second light L2 radiated from the fluorescent material travels in a light-exiting direction.D in which light exits from the light-emitting device 2. In the light-emitting device 2 of this embodiment, by virtue of the provision of the optical member 14, the deviation of the irradiation distribution of the first light L1a and L1b with respect to the wavelength converter 13 can be reduced.

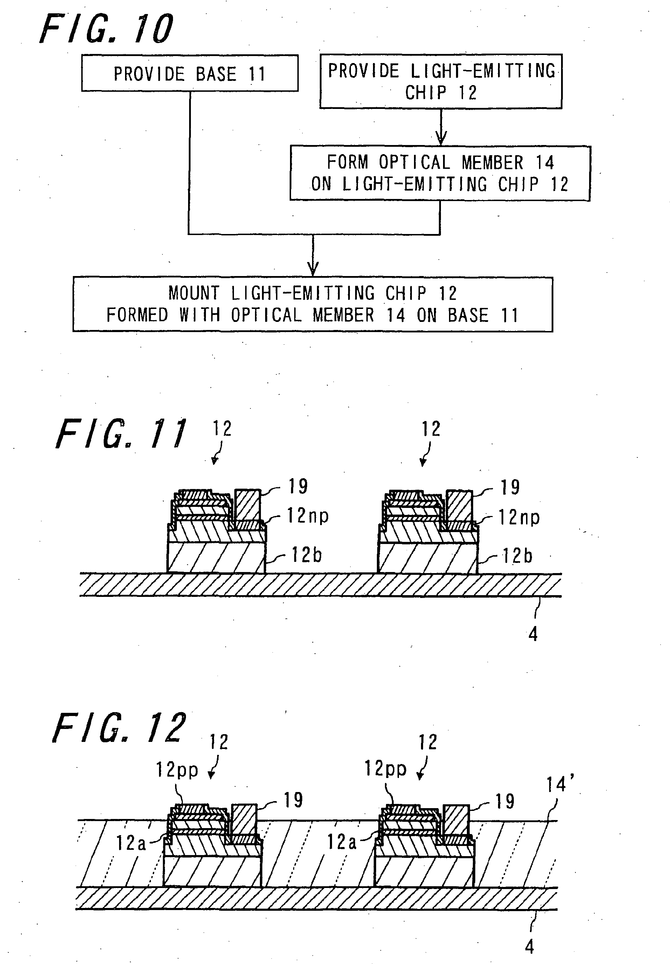

Hereinafter, a method for manufacturing the light-emitting device 2 of this embodiment will be described. As illustrated in Fig. 10, the method for manufacturing the light-emitting devices 2 includes the following steps A through D:
A) providing the base;
B) providing the light-emitting chip 12;
C) forming the optical member 14 on the light-emitting chip 12; and
D) mounting the light-emitting chip 12 formed with the optical member 14 on the base 11.

In Step B, the light-emitting chip 12 has the mounting surface M fitted with the first electrode pad (n-side electrode pad) 12np and the second electrode pad (p-side electrode pad) 12pp.

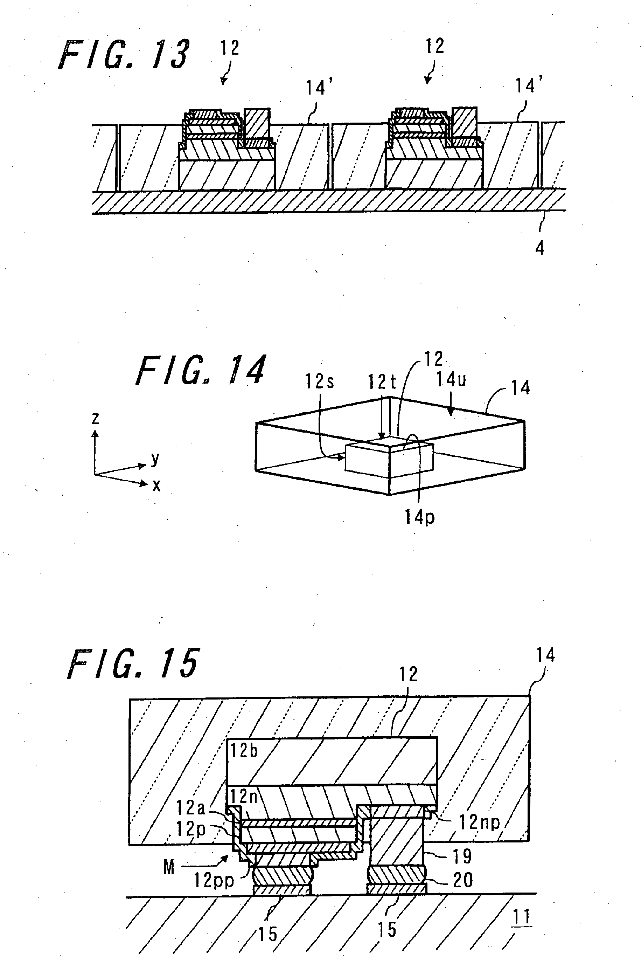

In Step C, the optical member 14 is formed on the side surfaces 12s of the light-emitting chip 12. The optical member 14 is formed at least on the side surface 12sn located nearest the n-side electrode pad 12np. Step C will be described in further detail. As illustrated in Fig. 11, a plurality of the light-emitting chips 12 are arranged on an adhesive film 4. The adhesive film 4 is adhered to the substrate 12b of the light-emitting chip 12. The light-emitting chip 12 includes the metal contact member 19 formed on the n-side electrode 12np. As illustrated in Fig. 12, a transparent material 14' in a molten state is admitted onto the adhesive film 4 so as to find its way into a region between the two or more light-emitting chips 12. The transparent material 14' covers the active layer 12a of the light-emitting chip 12. The p-side electrode 12pp and the metal contact member 19 of the light-emitting chip 12 are exposed from the transparent material 14'. For example, the transparent material 14' is cured by process of heating or otherwise. As illustrated in Fig. 13, the transparent material 14' in a cured state is cut off at a location between the two or more light-emitting chips 12. The adhesive film 4 is removed from the light-emitting chips 12 following the cutting of the transparent material 14'. In Step D, the light-emitting chip 12 is mounted on the base 11 in a state as illustrated in Fig. 5. In the light-emitting device of this embodiment, the optical member 14 is formed on the side surfaces of the light-emitting chip 12. This makes it possible to reduce the tilt of the light-emitting chip 12 in mounting.

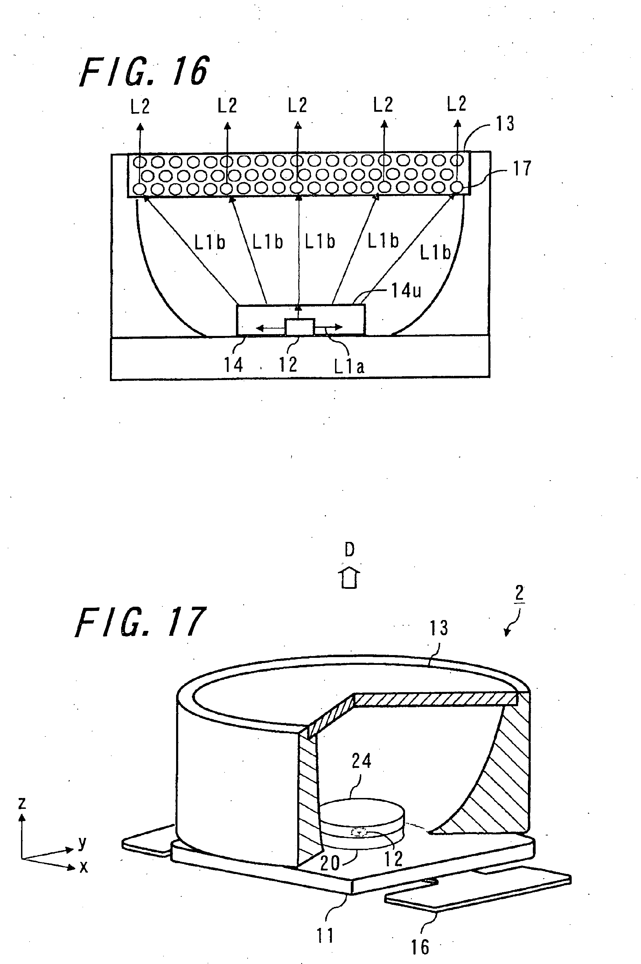

Another embodiment of the invention will be described. As illustrated in Figs. 14 and 15, the optical member 14 covers the active layer 12a of the light-emitting chip 12. The optical member 14 contacts with the side surface 12s and a top 12t of the light-emitting chip 12. The optical member 14 has the flat upper surface 14u opposed to the wavelength converter 13. The optical member 14 has the opening 14p in which is disposed the light-emitting chip 12. The optical member 14 contacts at least with the side surface 12s located nearest the p-side electrode pad 12p. The optical member 14 surrounds the side surfaces 12s and the top 12t of the light-emitting chip 12. Otherwise, this embodiment is structurally identical to the light-emitting device 2 illustrated in Fig. 3. As illustrated in Fig. 16, first light L1a emitted from the light-emitting chip 12 travels upward and sideward from the light-emitting chip 12. The first light L1a travels from the flat upper surface 14u of the optical member 14 toward the wavelength converter 13. The light radiated from the upper surface 14u is indicated by a symbol L1b. In the light-emitting device 2 of this embodiment, by virtue of the provision of the optical member 14, the deviation of the irradiation distribution of the first light L1b with respect to the wavelength converter 13 can be reduced.

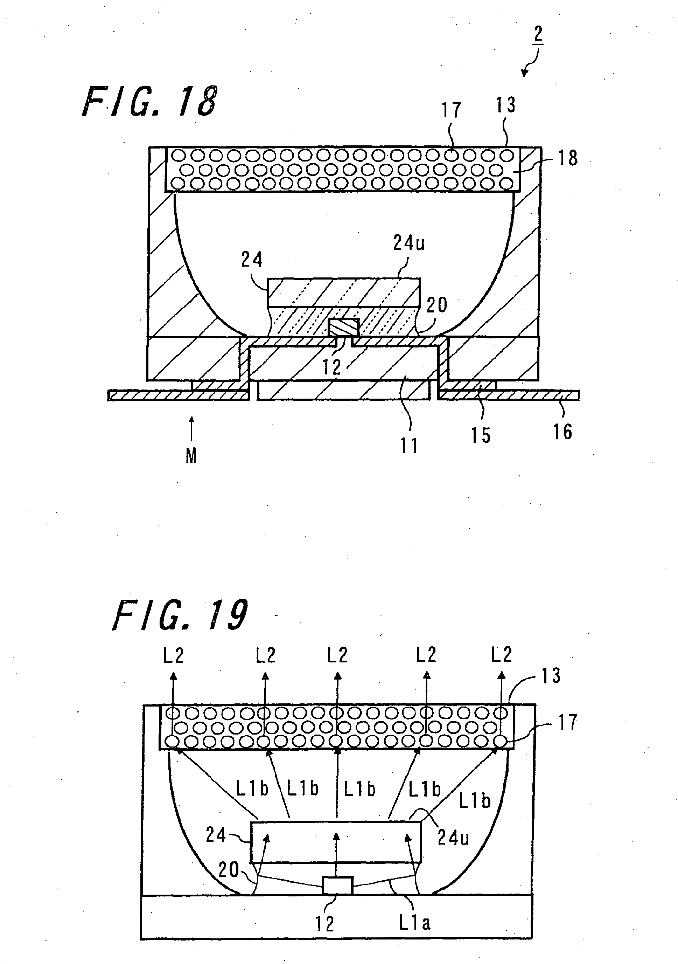

Still another embodiment of the invention will be described. As illustrated in Figs. 17 and 18, the light-emitting device 2 has an optical member 24 including a transparent material. In this embodiment, "transparent" refers to a property that allows light having at least part of the wavelengths of light generated by the light-emitting chip 12 to pass. The transparent material is glass or resin. The optical member 24 has a flat upper surface 24u opposed to the wavelength converter 13. The optical member 24 is placed between the light-emitting chip 12 and the wavelength converter 13. The upper surface 24u of the optical member 24 is apart from the wavelength converter 13. The light-emitting device 2 further includes a transparent resin 20 which surrounds the side surfaces and the top of the light-emitting chip 12. The transparent resin 20 is adhered to the optical member 24. Otherwise, this embodiment is structurally identical to the light-emitting device 2 illustrated in Fig. 3. As illustrated in Fig. 19, first light L1a emitted from the light-emitting chip 12 passes through the transparent resin 20 and is then radiated from the flat upper surface 24u of the optical member 24. The light radiated from the upper surface 24u is indicated by a symbol L1b. In the light-emitting device 2 of this embodiment, by virtue of the provision of the optical member 24, the deviation of the irradiation distribution of the first light L1b with respect to the wavelength converter 13 can be reduced.

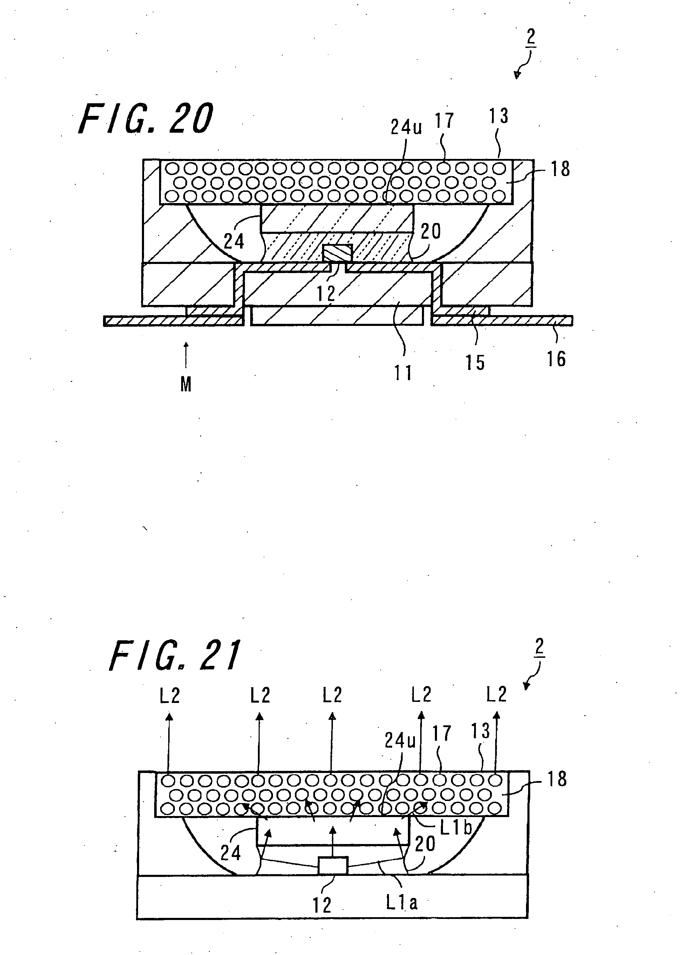

Yet a further embodiment of the invention will be described. As illustrated in Fig. 20, the upper surface 24u of the optical member 24 contacts with the wavelength converter 13. Otherwise, this embodiment is structurally identical to the light-emitting device 2 illustrated in Fig. 18. As illustrated in Fig. 21, first light L1a emitted from the light-emitting chip 12 passes through the transparent resin 20 and is then radiated from the flat upper surface 24u of the optical member 24. The light radiated from the upper surface 24u is indicated by a symbol L1b. In the light-emitting device 2 of this embodiment, by virtue of the provision of the optical member 24, the deviation of the irradiation distribution of the first light L1b with respect to the wavelength converter 13 can be reduced.

## Claims

1. A light-emitting device comprising:
a base;
a light-emitting chip mounted on the base, including a semiconductor material and generating a first light;
a light emitter disposed above the light-emitting chip, having a sheet-like shape and including a fluorescent material excited by the first light to emit a second light; and
an optical member contacting with side surfaces of the light-emitting chip, including a transparent material and having an opening in which the light-emitting chip is disposed and a flat upper surface opposed to the light emitter.

2. The light-emitting device of claim 1,
wherein the optical member covers an active layer of the light-emitting chip.

3. The light-emitting device of claim 2,
wherein the optical member surrounds the side surfaces of the light-emitting chip.

4. The light-emitting device of claim 3,
wherein the optical member surrounds a top of the light-emitting chip.

5. The light-emitting device of claim 1, further comprising:
a transparent material layer encapsulating the light-emitting chip and the optical member.

6. The light-emitting device of claim 5,
wherein the optical member has a first refractive index larger than a second refractive index of the transparent material layer.

7. The light-emitting device of claim 6,
wherein the optical member includes a glass material.

8. The light-emitting device of claim 7,
wherein the transparent material layer includes silicone resin.

9. The light-emitting device of claim 1,
wherein the light-emitting chip is mounted on the base by flip-chip bonding.

10. A method for manufacturing a light-emitting device comprising :
providing a base;
providing a light-emitting chip having a mounting surface including a first electrode pad and a second electrode pad;
forming an optical member on a side surface of the light-emitting chip; and
mounting the light-emitting chip formed with the optical member on the base, with the mounting surface opposed to the base.

11. The method of claim 10,
wherein the light-emitting chip includes a first semiconductor layer having the first electrode pad, an active layer stacked on the first semiconductor layer, and a second semiconductor layer having the second electrode pad, which is stacked on the active layer.

12. The method,of claim 11,
wherein the optical member is formed on the side surface of the light-emitting chip which is located nearest the first electrode pad.

13. The method of claim 12,
wherein the optical member surrounds side surfaces of the light-emitting chip.

14. The method of claim 11,
wherein the light-emitting chip further includes a metal contact member formed on the.first electrode pad.

15. The method of claim 14,
wherein the forming an optical member has adhering a transparent material in a molten state, which is a material for constituting the optical member, to the side surface of the light-emitting chip on which is formed the metal contact member.

16. A light-emitting device comprising:
a base;
a light-emitting chip mounted on the base, including a semiconductor material and generating a first light;
a light emitter disposed above the light-emitting chip, haying a sheet-like shape and including a fluorescent material excited by the first light to emit a second light; and
an optical member disposed between the light-emitting chip and the light emitter, including a transparent material and having a flat upper surface opposed to the light emitter.

17. The light-emitting device of claim 16,
wherein the upper surface of the optical member is apart from the light emitter.

18. The light-emitting device of claim 16,
wherein the upper surface of the optical member contacts with the light emitter.
